# EUROPÄISCHE PATENTSCHRIFT

(11) **EP 2 580 363 B1**
(45) Veröffentlichungstag und Bekanntmachung des Hinweises auf die Patenterteilung: **12.06.2019**
(21) Anmeldenummer: 11716209.9
(22) Anmeldetag: 15.04.2011
(51) Int. Cl.: C22C 1/04, C22C 19/07, H01L 35/08, H01L 35/18

(54) **HALB-HEUSLER/HEUSLER-LEGIERUNGEN MIT MAßGESCHNEIDERTER PHASENSEPARATION**
SEMI-HEUSLER/HEUSLER ALLOYS HAVING TAILORED PHASE SEPARATION
ALLIAGES SEMI-HEUSLER/HEUSLER PRÉSENTANT UNE SÉPARATION DE PHASES SUR MESURE

(30) Priorität: 11.06.2010 DE 102010029968
(43) Veröffentlichungstag der Anmeldung: 17.04.2013
(73) Patentinhaber: Robert Bosch GmbH, 70442 Stuttgart (DE)
(72) Erfinder: KOEHNE, Martin, 71679 Asperg (DE); GRAF, Tanja, 65343 Eltville (DE); ELMERS, Hans Joachim, 55288 Partenheim (DE); FELSER, Claudia, 55131 Mainz (DE)
(86) Internationale Anmeldenummer: PCT/EP2011/056000
(87) Internationale Veröffentlichungsnummer: WO 2011/154189

(56) Entgegenhaltungen:
- EP-A2- 1 738 381
- WO-A1-2011/006034
- JP-A- 2005 019 713
- US-A1- 2005 217 715
- GRAF T ET AL: "Phase separation in the quaternary Heusler compound CoTi(1-x)MnxSb - A reduction in the thermal conductivity for thermoelectric applications", SCRIPTA MATERIALIA, ELSEVIER, AMSTERDAM, NL, Bd. 63, Nr. 12, 1. Dezember 2010 (2010-12-01), Seiten 1216-1219, XP027400416, ISSN: 1359-6462 [gefunden am 2010-08-24]

## Beschreibung

### Stand der Technik

Thermoelektrische Materialen erzeugen eine elektrische Spannung, wenn sie einem Temperaturgefälle ausgesetzt sind. Dies wird in thermoelektrischen Generatoren genutzt, um elektrische Energie zu produzieren. Jedoch liegt der Wirkungsgrad bei der Umwandlung eines Temperaturgradienten in Strom bei den bisher verwendeten Materialien bei unter 10 Prozent. Um einen besseren Wirkungsgrad zu erzielen, sind daher Materialen notwendig, die elektrischen Strom gut, Wärme dagegen schlecht leiten. Gute Stromleiter, die in der Regel ebenso gute Wärmeleiter sind, zeichnen sich auf atomarer Ebene durch eine regelmäßige Gitterstruktur aus. Elektrizität breitet sich darin in Form von Elektronenströmen aus, Wärme in Form von Gitterschwingungen. Unregelmäßigkeiten in der Gitterstruktur, etwa fehlende Atome, können zwar die Wärmeleitfähigkeit verringern, beeinträchtigen aber auch die elektrische Leitfähigkeit.
Sind jedoch einzelne Atome in kristallinen Käfigstrukturen eingefangen, unabhängig von den Kristallgittern, schwingen diese Atome und verringern damit - durch Störung der Wärmewellen - die Wärmeleitfähigkeit. Die elektrische Leitfähigkeit wird dadurch jedoch nicht behindert.

Die Entwicklung kostengünstiger, umweltverträglicher und ressourcenschonender thermoelektrischer Volumenmaterialien eröffnet erstmalig die Perspektive, thermoelektrische Generatoren für die Energiegewinnung aus Abwärme in Großserie herzustellen. Diese thermoelektrischen Generatoren können in zahlreichen Anwendungen eingesetzt werden, um die bisher energetisch nicht genutzte Abwärme für die Stromerzeugung nutzbar zu machen. Beispiele für ihre Anwendungen sind die Stromgewinnung aus Abwärme im Abgasstrang eines Automobils oder aus der Heißgasabwärme industrieller thermischer Prozesse.

Eines, der für thermoelektrische Generatoren in Frage kommenden Volumenmaterialien, sind Halb-Heusler-Legierungen. Diese Materialklasse der Heuslerschen Legierungen zeichnet sich unter anderem dadurch aus, dass bestimmte Heuslersche Legierungen aus nichtmagnetischen Metallen ferromagnetisch sind.

Bis heute sind mehr als 250 Halb-Heusler-Legierungen bekannt, fast alle sind Halbleiter oder Halbmetalle, die meisten mit relativ kleinen Bandlücken, was sie im Hinblick auf ihre guten thermoelektrischen Eigenschaften interessant macht.

Eine Schwierigkeit bei den bisher verwendeten Halb-Heusler Verbindungen ist die relative hohe thermische Leitfähigkeit λ in einer Größenordnung von etwa 10 W/mK.

Beispielsweise offenbart EP 1738381 A2 eine Herstellungsmethode für eine thermoelektrische Halbleiterlegierung und einen thermoelektrischen Generator mit einer thermoelektrische Halbleiterlegierung. Die thermoelektrischen Halbleiter umfassen Skutterudit, Kobaltoxid, Silizide und Heuslersche Legierung.

US 2005/0217715 A1 offenbart ein thermoelektrisches Material. Die Zusammensetzung umfasst mindestens zwei kristalline Phasen vom MgAgAs-Typ. Beide Phasen sind Halb-Heusler-Verbindungen, wobei die Halb-Heusler-Verbindung TiNiSn halbleitend ist.

Aus JP 2005/019713 A ist eine Halb-Heusler-Legierung bekannt, die mehrere verschiedene Phasen ausbildet. Die darin enthaltene TiNiSn-Phase ist eine intermetallische Verbindung und ist halbleitend.

Nach dem bisherigen Stand der Wissenschaft gibt es für Halb-Heusler-Legierungen keine Technik die Wärmeleitfähigkeit durch intrinsische Nanostrukturierung zu reduzieren.

### Offenbarung der Erfindung

Der Kern der Erfindung liegt darin, bei der Herstellung einer Halb-Heusler-Legierungen zu den Elementen, die in der Halb-Heusler-Legierung bereits enthalten sind, ein weiteres Element hinzuzufügen, das mit einem Teil der Elemente der Halb-Heusler-Legierung eine zweite Phase bildet, die mit der Halb-Heusler-Legierung nicht mischbar ist.

Die Erfindung erlaubt die Reduzierung der Wärmeleitfähigkeit von Halb-Heusler-Legierungen bei gleichzeitiger Erhaltung der elektrischen Leitfähigkeit und der Thermospannung. Darüber hinaus ist es Aufgabe der Erfindung selbstorganisierende Mikro- und Nanostrukturen in Halb-Heusler-Legierungen zu erzeugen.

Heusler-Legierungen besitzen als wesentlichen Bestandteil eine Heusler-Phase. Heusler-Phasen sind intermetallische Phasen, oder auch intermetallische Verbindungen, mit spezieller Zusammensetzung und Gitterstruktur. Sie sind ferromagnetisch, obwohl die darin enthaltenen Legierungselemente diese Eigenschaft nicht aufweisen.

Die Halb-Heusler-Phasen haben allgemein eine Zusammensetzung XYZ, wobei jeder Buchstabe für ein Legierungselement steht, während die vollständigen Heusler-Phasen nach dem Schema X₂YZ zusammengesetzt sind. Dabei sind X und Y Übergangsmetalle, während Z ein Element der III.-V. Hauptgruppe ist. Die Legierungselemente bilden Ordnungsphasen, so dass die Kristallstruktur aus vier (beim XYZ-Typ ist eines unbesetzt) ineinander verschachtelten kubischflächenzentrierten Teilgittern besteht. Die Wechselwirkungen zwischen den Atomen der Teilgitter bewirken eine nahezu vollständige Ausrichtung (Spinpolarisation) der magnetischen Dipolmomente, was sich makroskopisch als Ferromagnetismus äußert.

Unter intermetallischen Verbindungen werden Verbindungen
1. zwischen zwei oder mehr echten Metallen (T1 und T2),
2. zwischen einem oder mehreren echten Metallen und einem oder mehreren Metallen der B-Untergruppe,
3. zwischen zwei oder mehr Metallen der B-Untergruppe
verstanden, wobei die Eigenschaften beim Übergang von der 1. zur 3. Klasse weniger metallisch und zunehmend echten chemischen Verbindungen ähnlicher werden.

Eine intermetallische Halb-Heusler Phase bestehend aus 3 Elementen (X, Y, Z) pro Formeleinheit und 8 beziehungsweise 18 Valenzelektronen ist meist ein Halbleiter oder Halbmetalle. Dabei können die Elemente auch mit Elementen mit gleicher Valenzelektronenzahl substituiert werden. Die f-Elektronen der Lanthaniden und Actiniden zählen hierbei nicht als Valenzelektronen.

Aufgrund der strukturellen Eigenart der Halb-Heusler-Legierungen bieten sich vielfältige Möglichkeiten die thermoelektrischen Eigenschaften zu verbessern.

Eine Möglichkeit die Wärmeleitfähigkeit von thermoelektrischen Materialien zu reduzieren ist, im Material Strukturen zu schaffen, an denen Phononen, daher Quasiteilchen, durch die die Wärme transportiert wird, gestreut, Elektronen aber in ihrem Fluss nicht gehindert werden. Dadurch wird die Wärmeleitfähigkeit reduziert ohne die elektrische Leitfähigkeit zu verschlechtern.

Eine Methode ist die Dotierung der Verbindung, indem ein Element durch ein anderes Element (mit mehr oder weniger Valenzelektronen) aus einer angrenzenden Gruppe des Periodensystems partiell ersetzt wird. Dadurch kann die elektrische Leitfähigkeit erhöht werden. Außerdem ist durch die Dotierung die Einstellung als n- bzw. p-Leiter möglich.
Durch diese Variationsmöglichkeiten ist auch für eine einzelne Halb-Heusler-Legierung eine sehr hohe Anzahl an Verbindungen möglich.

Eine weitere Methode ist die Teilsubstitution beziehungsweise mehrfache Teilsubstitution mit Elementen derselben Gruppe, um eine weitere Reduzierung der Wärmeleitfähigkeit beziehungsweise eine Steigerung des Seebeckkoeffizienten durch Maßschneidern des Elektronensystems (bandgap-engineering) zu erzielen.

Dieser Ansatz setzt voraus, dass sich das Material so synthetisieren lässt, dass zwei nicht miteinender mischbare Phasen entstehen, die beide thermodynamisch stabil sind. Gelingt es dabei Strukturen zu erzeugen die im Bereich < 5 µm, bevorzugt kleiner < 1 µm, besonders bevorzugt < 100 nm liegen, sind diese Strukturen geeignet die Wärmeleitfähigkeit zu reduzieren. Die Entmischung ist optimal, wenn die erzeugten Strukturen im nm-Bereich, vorzugsweise < 10 nm liegen.

Mittels solcher Materialien lässt sich beispielsweise der Wirkungsgrad thermoelektrischer Generatoren steigern, da diese mit Hilfe einer Temperaturdifferenzen Strom herstellen. Dies wird als Seebeckeffekt bezeichnet. Damit ließe sich zum Beispiel bisher ungenutzte Abwärme, beispielsweise in einem Fahrzeug oder aus der Heißgasabwärme industrieller thermischer Prozesse, zunehmend wirtschaftlich nutzen.

Durch teilweises Ersetzen mindestens eines Elementes in der Halb-Heusler Struktur kommt es zu metallischen Einschlüssen in der halbleitenden oder halbmetallischen Matrix. Sind in dieser Matrix metallische Einschlüsse, so kann es in Folge der Streuung von Phononen an der Phasengrenze Matrix-"metallische Einschlüsse" zu einer signifikanten Reduktion der Wärmeleitfähigkeit kommen.

Erfindungsgemäße Verbindungen sind demnach solche anorganischen, intermetallischen Verbindungen, die mindestens zwei Elemente pro Formeleinheit enthalten, aus mindestens 2 Phasen bestehen, wobei mindestens eine halbleitend oder halbmetallisch ist.

Bei der Hauptphase (mindestens 70% des Gesamtanteils der Verbindung) handelt es sich bevorzugt um intermetallische Verbindung, die eine kubische Symmetrie mit vorzugsweise keiner, gegebenenfalls geringer struktureller Verzerrung aufweisen. Unter struktureller Abweichung wird eine Verzerrung der Gitterparameter um mehr als 10% von der Kristallstruktur der Elementarzelle verstanden.

Die kubische Symmetrie wird in erster Nährung von den Radienverhältnissen der Atome bestimmt. Idealerweise wählt man die Elemente und die Stöchiometrie in der Weise aus, dass die resultierende Hauptphase zu den Halb-Heusler-Phasen zählt und 18 Valenzelektronen besitzt.

Weiterhin zweckmäßig ist, dass die erfindungsgemäßen Verbindungen ein halbleitendes Verhalten oder einen Metall-Halbleiterübergang beziehungsweise einen Metall-Halbmetallübergang zeigen.

Die mindestens eine Nebenphase (weniger als 30% des Gesamtanteils der Verbindung, zur Vermeidung einer metallischen Phase bevorzugt weniger als 5% des Gesamtanteils der Verbindung) sind metallische Einschlüsse ungeordneter Struktur. Teile der mindestens einen Nebenphase sind zu kleinen Bereichen zusammengeschlossen, die jedoch untereinander unverbunden sind, daher keine Verbindung zueinander besitzen.

Die mindestens eine Nebenphase entsteht während des Herstellungsprozesses der anorganischen, intermetallischen Verbindung und muß nicht nachträglich eingebracht werden.

Mindestens eine der entstehenden Nebenphasen sollte metallisch sein.

Die erfindungsgemäße anorganischen, intermetallischen Verbindung zeichnet sich durch eine niedrige Wärmeleitfähigkeit < 4 W/mK bei gleichzeitig hoher elektrischer Leitfähigkeit > 1,8x10⁵ S/m aus. Die anorganische, intermetallische Verbindung besitzt einen Seebeckkoeffizient > ± 100 uV/K, eine hohe thermische Zersetzungsstabilität und chemische Stabilität.

### Ausführungsvarianten

Vorrausetzung für eine Mikrostrukturierung sind zwei Halb-Heusler (XYZ) oder zwei Heusler Verbindungen (X₂YZ) oder eine Heusler und eine Halb-Heusler Verbindung die nicht miteinander mischbar sind. Dies ist immer der Fall zwischen Heusler Verbindungen von denen die eine frühe Übergangsmetalle oder Seltenerdatome auf den Oktaederlücken (Y-Plätze) und die andere Verbindung späten Übergangmetall auf den Oktaederlücken (Y-Plätze) besitzt.

Die Probenherstellung kann auf verschiedenem Wege erfolgen.

Zum einen kann Pulver oder Metallstücke der verwendeten Elemente in einem bestimmten stöchiometrischen elementenabhängigen Verhältnis oder auch die Verbindungen separat eingewogen werden.

Das Aufschmelzen erfolgt vorzugsweise in einem Lichtbogenofen unter Schutzgasatmosphäre. Bei der Probenherstellung ist besonders auf eine Sauerstoff- und wasserfreie Atmosphäre zu achten. Um eine homogene Probe zu erhalten werden die Proben nach dem ersten Schmelzen gedreht und von der anderen Seite ebenfalls aufgeschmolzen.

Die Proben können zur besseren Homogenisierung anschließend einer zusätzlichen Wärmebehandlung unterzogen werden. Dazu werden die Proben in eine evakuierte Quarzglasampulle eingeschmolzen und in einem Röhrenofen (Carbolite) zwischen 700°C und 1000°C ein bis vier Wochen gehalten. Anschließend werden die Ampullen abgeschreckt, indem sie direkt aus dem Röhrenofen in Eiswasser gestoßen werden (Quenchen), um die Modifikation bei der entsprechenden Temperatur festzuhalten.

Es ist aber ebenfalls möglich, die Verbindung aus den Elementen, eingeschmolzen in Quarzampullen, unter Schutzgas-Atmosphäre oder Vakuum bei Temperaturen von mehr als 400°C zu sintern.

Eine weitere Möglichkeit der Probenherstellung ist die Herstellung über Kugelmahlen.

Dabei wiegt man die Elemente in Pulverform in der entsprechenden Stöchiometrie ein und gibt das Pulvergemisch in einen Mahlbecher mit Mahlkugeln. Der Mahlbecher wir unter Schutzatmosphäre luftdicht verschlossen, um eine Oxidation der Probe während des Herstellungsprozesses zu vermeiden und anschließend in eine Planetenkugelmühle gespannt.

Nach ca. 10 Stunden des Mahlens - der Prozess muss pro Stunde für ca. 20 min unterbrochen werden um eine Überhitzung zu vermeiden - entsteht die Halb-Heusler Verbindung.

Eine weitere Methode das durch Kugelmahlen erhaltene Pulver der Verbindung zu verdichten, ist der Prozess des Spark-Plasma-Sinterns. Dabei wird die Probe im heißen Zustand hochverdichtet. Typische Werte für das Spark-Plasma-Sintern von Halb-Heusler Verbindungen sind bei einer Temperatur zwischen 1000K und 1300K ca. 50MPa für 5-20 Minuten. Der Vorteil des Spark-Plasma-Sinterns, im Vergleich zum Heißpressen, liegt in der niedrigeren Prozesstemperatur und der höheren Sintergeschwindigkeit. Dadurch wird im Gegensatz zum Heißpressen ein Kornwachstum weitestgehend vermieden.

Andere Verfahren, wie Herstellung der Pulver aus den Elementen durch Reaktion unter Schutzgas in der Kugelmühle und anschließendem Schmelzspinnen (melt spinning) oder auch Aufschmelzen der Elementgemenge im Induktionsofen, sind ebenfalls möglich.

### Ausführungsbeispiele

Im Folgenden wird die Erfindung anhand von Beispielen und Figuren näher erläutert.

Es zeigen:
- Figur 1: Eine Röntgenstrukturmessung an, durch verschiedene Verfahren hergestellte, CoTiSb Proben und eine Vergleichsmessung einer I:I:I-Mischung der Elemente,
- Figur 2: Raster-Elektronenmikroskop-Aufnahmen von einem Gefüge und einer Elementverteilung in CoTi_{0,5}Mn_{0,5}Sb und
- Figur 3: Raster-Elektronenmikroskop-Aufnahmen von einem Gefüge und einer Elementverteilung in Co₂Ti₁₋ₓMnₓSn.

### Nicht-erfindungsgemäßes Beispiel 1:

Herstellung eines mikrostrukturierten Materials aus zwei Halb-Heusler-Verbindungen (CoTiSb : CoMnSb im Verhältnis 1:1)

Die Verbindung CoTiSb ist nicht mischbar mit CoMnSb, da eine Mischungslücke zwischen den beiden Verbindungen besteht.

CoTiSb ist ein Halbleiter, CoMnSb ein halbmetallischer Ferromagnet.

Pulver oder Metallstücke der vier Elemente Co:Ti:Mn:Sb werden in den stöchiometrischen Verhältnissen 2:1:1:2 oder auch die beiden Verbindungen Co:Ti:Sb und Co:Mn:Sb separat im Verhältnis 1:1:1 eingewogen. Anschließend erfolgt das Aufschmelzen im Lichtbogenofen unter Schutzgasatmosphäre.

Bei der Probenherstellung durch Kugelmahlen wiegt man die Elemente in Pulverform in dem stöchiometrischen Verhältnis 2:1:1:2 ein und gibt das Pulvergemisch in einen Mahlbecher aus Zirkonoxid mit Mahlkugeln aus Zirkonoxid. Der Mahlbecher wir unter Argon luftdicht verschlossen, in eine Planetenkugelmühle (Fa. Retsch, PM100) gespannt und für ca. 10 Stunden, mit einer Unterbrechung von ca. 20 Minuten pro Stunde, gemahlen.

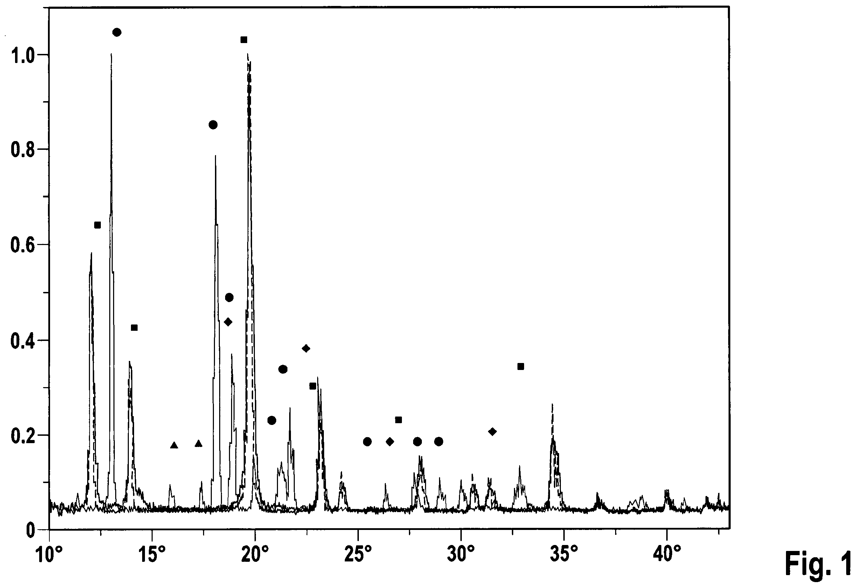

Figur 1 zeigt Röntgenstrukturmessung an durch verschiedene Verfahren hergestellte CoTiSb Proben. Die im Lichtbogenofen (arcmelting) hergestellt Probe und eine Probe die für 13 Stunden in der Kugelmühle (13h ball milling) hergestellt wurde. Im Vergleich dazu die Messung einer I:I:I-Mischung der Elemente.

Man sieht deutlich, dass nach 13 Stunden des Mahlens die Elemente nicht mehr vorhanden sind, sondern komplett zur Halb-Heusler Verbindung übergegangen sind und dieselbe Struktur entsteht wie durch den Lichtbogenofenprozess.

Um anschließend an den Proben magnetische und thermoelektrische Eigenschaften, sowie die Transporteigenschaften zu messen, wird das frisch hergestellte Pulver mit Hilfe einer hydraulischen Presse bei ca. 60kN zu einer Scheibe oder zu einem Stab gepresst.

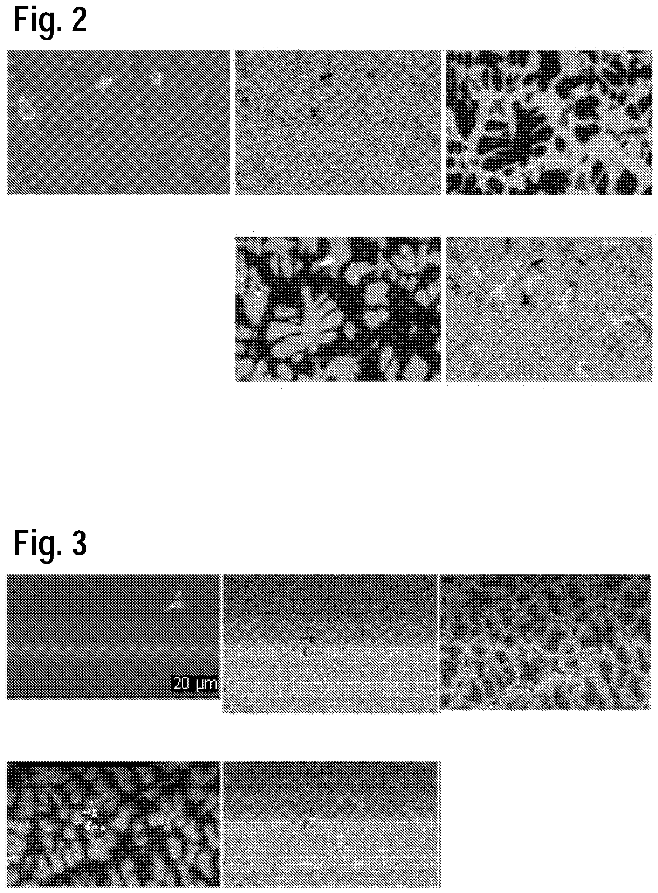

Außerdem werden die Proben röntgenografisch auf die korrekte Struktur untersucht und anschließend in einem Raster-Elektronenmikroskop (REM) in Kombination mit EDX (energiedispersive Röntgenspektroskopie) auf das Entmischungsverhalten untersucht (siehe Figur 2).

### Beispiel 2:

Herstellung eines mikrostrukturierten Materials aus zwei Heusler-Verbindungen (Co₂TiSn : Co₂MnSn im Verhältnis 1:1)

Die Verbindung Co₂TiSn ist nicht mischbar mit Co₂MnSn, da eine Mischungslücke zwischen den beiden Verbindungen besteht.

Die Probenherstellung kann auf verschiedenen Wegen erfolgen. Zum einen kann Pulver oder Metallstücke der vier Elemente Co:Ti:Mn:Sn in den stöchiometrischen Verhältnissen 4:1:1:2 oder auch die beiden Verbindungen Co:Ti:Sn und Co:Mn:Sn separat im Verhältnis 2:1:1 eingewogen werden.

Das Aufschmelzen erfolgt vorzugsweise in einem Lichtbogenofen unter Schutzgasatmosphäre.

Anschließend wird das Gewicht kontrolliert. Dabei werden Proben mit einem Massenverlust von mehr als 1% verworfen.

Die Proben werden röntgenografisch auf die korrekte Struktur hin untersucht und anschließend in einem Raster-Elektronenmikroskop (REM) in Kombination mit EDX (energiedispersive Röntgenspektroskopie) auf das Entmischungsverhalten untersucht (siehe Figur 3). Die Größe der Ausscheidungen kann über den Abkühlungsprozess kontrolliert werden.

## Patentansprüche

1. Anorganische, intermetallische Verbindung, **dadurch gekennzeichnet, dass** die Verbindung mindestens zwei Phasen enthält, wobei die Verbindung mindestens eine Heusler-Phase und zusätzlich mindestens eine andere Heusler-Phase oder eine Halb-Heusler-Phase umfasst, wobei die Bildung der Phasen während der Synthese der Verbindung erfolgt ist und die Phasen nicht mischbar sind, thermodynamisch stabil sind und die Phasen halbleitend oder halbmetallisch sind.

2. Anorganische, intermetallische Verbindung, nach Anspruch 1, **dadurch gekennzeichnet, dass** durch die Separation der mindestens zwei Phasen ungeordnete Strukturen < 1 µm, bevorzugt Strukturen < 100 nm und besonders bevorzugt Strukturen < 30 nm_ausgebildet werden.

3. Anorganische, intermetallische Verbindung, nach einem oder mehreren der vorhergehenden Ansprüche, **dadurch gekennzeichnet, dass** die anorganische, intermetallische Verbindung eine Hauptphase besitzt, die mindestens 70% des Gesamtanteils der anorganischen, intermetallischen Verbindung umfasst.

4. Anorganische, intermetallische Verbindung, nach Anspruch 3, **dadurch gekennzeichnet, dass** die Hauptphase eine intermetallische Verbindung ist.

5. Anorganische, intermetallische Verbindung, nach Anspruch 3 oder 4, **dadurch gekennzeichnet, dass** die Hauptphase eine kubische Symmetrie mit vorzugsweise keiner, gegebenenfalls geringer struktureller Abweichung besitzt, wobei strukturelle Abweichung eine Verzerrung der Gitterparameter um weniger als 10% verstanden wird.

6. Anorganische, intermetallische Verbindung, nach Anspruch 3 bis 5, **dadurch gekennzeichnet, dass** die Verbindung mindestens eine Heusler-Phase und zusätzlich mindestens eine Halb-Heusler-Phase umfasst und die Hauptphase den Halb-Heusler-Phasen angehört.

7. Anorganische, intermetallische Verbindung, nach Anspruch 3 bis 6, **dadurch gekennzeichnet, dass** die Hauptphase 18 Valenzelektronen besitzt.

8. Anorganische, intermetallische Verbindung, nach Anspruch 3 bis 7, **dadurch gekennzeichnet, dass** die Hauptphase ein halbleitendes Verhalten besitzt.

9. Anorganische, intermetallische Verbindung, nach Anspruch 3 bis 7, **dadurch gekennzeichnet, dass** die Hauptphase semimetallisches Verhalten besitzt.

10. Anorganische, intermetallische Verbindung, nach einem oder mehreren der vorhergehenden Ansprüche, **dadurch gekennzeichnet, dass** die anorganische, intermetallische Verbindung eine Nebenphase besitzt, die weniger als 30% des Gesamtanteils der anorganischen, intermetallischen Verbindung umfasst.

11. Anorganische, intermetallische Verbindung, nach Anspruch 10, **dadurch gekennzeichnet, dass** die Nebenphase metallische Einschlüsse mit einer ungeordneten Struktur umfasst.

12. Anorganische, intermetallische Verbindung, nach Anspruch 11, **dadurch gekennzeichnet, dass** die Nebenphase während des Herstellungsprozesses entsteht.

13. Anorganische, intermetallische Verbindung, nach einem oder mehreren der vorhergehenden Ansprüche, **dadurch gekennzeichnet, dass** die anorganische, intermetallische Verbindung Hauptbestandteil einer Legierung ist.

14. Anorganische, intermetallische Verbindung nach einem oder mehreren der vorhergehenden Ansprüche, **dadurch gekennzeichnet, dass** die Verbindung zwei Phasen in einem Mischungsverhältnis von 1:1 enthält.

## Claims

1. Inorganic, intermetallic compound, **characterized in that** the compound contains at least two phases, where the compound comprises at least one Heusler phase and additionally at least one other Heusler phase or a semi-Heusler phase, where the formation of the phases has occurred during the synthesis of the compound and the phases are immiscible, are thermodynamically stable and the phases are semiconducting or semimetallic.

2. Inorganic, intermetallic compound according to Claim 1, **characterized in that** disordered structures of < 1 µm, preferably structures of < 100 nm and particularly preferably structures of < 30 nm, are formed by the separation of the at least two phases.

3. Inorganic, intermetallic compound according to one or more of the preceding claims, **characterized in that** the inorganic, intermetallic compound has a main phase which makes up at least 70% of the total amount of the inorganic, intermetallic compound.

4. Inorganic, intermetallic compound according to Claim 3 **characterized in that** the main phase is an intermetallic compound.

5. Inorganic, intermetallic compound according to Claim 3 or 4, **characterized in that** the main phase has a cubic symmetry which preferably has no structural deviation, optionally a small structural deviation, where a structural deviation is a distortion of the lattice parameters by less than 10%.

6. Inorganic, intermetallic compound according to any of Claims 3 to 5, **characterized in that** the compound comprises at least one Heusler phase and in addition at least one semi-Heusler phase and the main phase belongs to the semi-Heusler phases.

7. Inorganic, intermetallic compound according to any of Claims 3 to 6, **characterized in that** the main phase has 18 valence electrons.

8. Inorganic, intermetallic compound according to any of Claims 3 to 7, **characterized in that** the main phase has semiconductive behaviour.

9. Inorganic, intermetallic compound according to any of Claims 3 to 7, **characterized in that** the main phase has semimetallic behaviour.

10. Inorganic, intermetallic compound according to one or more of the preceding claims, **characterized in that** the inorganic, intermetallic compound has a secondary phase which makes up less than 30% of the total amount of the inorganic, intermetallic compound.

11. Inorganic, intermetallic compound according to Claim 10, **characterized in that** the secondary phase comprises metallic inclusions having a disordered structure.

12. Inorganic, intermetallic compound according to Claim 11, **characterized in that** the secondary phase is formed during the production process.

13. Inorganic, intermetallic compound according to one or more of the preceding claims, **characterized in that** the inorganic, intermetallic compound is main constituent of an alloy.

14. Inorganic, intermetallic compound according to one or more of the preceding claims, **characterized in that** the compound contains two phases in a mixing ratio of 1:1.

## Revendications

1. Composé intermétallique inorganique, **caractérisé en ce que** le composé contient au moins deux phases, le composé comprenant au moins une phase de Heusler et en outre au moins une autre phase de Heusler ou une phase semi-Heusler, la formation des phases ayant lieu pendant la synthèse du composé, et les phases n'étant pas miscibles, étant thermodynamiquement stables, et les phases étant semi-conductrices ou semi-métalliques.

2. Composé intermétallique inorganique selon la revendication 1, **caractérisé en ce que** des structures désordonnées < 1 µm, de préférence des structures < 100 nm et de manière particulièrement préférée des structures < 30 nm, sont formées par la séparation desdites au moins deux phases.

3. Composé intermétallique inorganique selon une ou plusieurs des revendications précédentes, **caractérisé en ce que** le composé intermétallique inorganique comporte une phase principale qui comprend au moins 70 % de la proportion totale du composé intermétallique inorganique.

4. Composé intermétallique inorganique selon la revendication 3, **caractérisé en ce que** la phase principale est un composé intermétallique.

5. Composé intermétallique inorganique selon la revendication 3 ou 4, **caractérisé en ce que** la phase principale présente une symétrie cubique avec de préférence aucune, éventuellement peu de déviation structurale, une déviation structurale étant comprise comme une déformation des paramètres du réseau de moins de 10 %.

6. Composé intermétallique inorganique selon les revendications 3 à 5, **caractérisé en ce que** le composé comprend au moins une phase de Heusler et en outre au moins une phase semi-Heusler, et la phase principale fait partie des phases semi-Heusler.

7. Composé intermétallique inorganique selon les revendications 3 à 6, **caractérisé en ce que** la phase principale comprend 18 électrons de valence.

8. Composé intermétallique inorganique selon les revendications 3 à 7, **caractérisé en ce que** la phase principale présente un comportement semi-conducteur.

9. Composé intermétallique inorganique selon les revendications 3 à 7, **caractérisé en ce que** la phase principale présente un comportement semi-métallique.

10. Composé intermétallique inorganique selon une ou plusieurs des revendications précédentes, **caractérisé en ce que** le composé intermétallique inorganique comporte une phase secondaire qui comprend moins de 30 % de la proportion totale du composé intermétallique inorganique.

11. Composé intermétallique inorganique selon la revendication 10, **caractérisé en ce que** la phase secondaire comprend des inclusions métalliques ayant une structure désordonnée.

12. Composé intermétallique inorganique selon la revendication 11, **caractérisé en ce que** la phase secondaire est formée pendant le procédé de fabrication.

13. Composé intermétallique inorganique selon une ou plusieurs des revendications précédentes, **caractérisé en ce que** le composé intermétallique inorganique est le constituant principal d'un alliage.

14. Composé intermétallique inorganique selon une ou plusieurs des revendications précédentes, **caractérisé en ce que** le composé contient deux phases en un rapport de mélange de 1:1.
